# NEUE EUROPÄISCHE PATENTSCHRIFT

(11) **EP 1 611 613 B2**
(45) Veröffentlichungstag und Bekanntmachung des Hinweises auf die Entscheidung über den Einspruch: **16.01.2019**
(45) Hinweis auf die Patenterteilung: 02.03.2016
(21) Anmeldenummer: 04724012.2
(22) Anmeldetag: 29.03.2004
(51) Int. Cl.: H01L 29/32

(54) **VERFAHREN ZUR HERSTELLUNG EINES HALBLEITERBAUELEMENTS**
METHOD FOR PRODUCING A SEMICONDUCTOR COMPONENT
PROCEDE DE PRODUCTION D'UN COMPOSANT A SEMI-CONDUCTEURS

(30) Priorität: 09.04.2003 DE 10316222
(43) Veröffentlichungstag der Anmeldung: 04.01.2006
(73) Patentinhaber: Infineon Technologies AG, 85579 Neubiberg (DE)
(72) Erfinder: BARTHELMESS, Reiner, 59494 Soest (DE); SCHULZE, Hans-Joachim, 85521 Ottobrunn (DE)
(74) Vertreter: Westphal, Mussgnug & Partner Patentanwälte mbB
(86) Internationale Anmeldenummer: PCT/EP2004/003321
(87) Internationale Veröffentlichungsnummer: WO 2004/090987

(56) Entgegenhaltungen:
- EP-A- 0 837 506
- EP-A- 1 298 717
- DE-A1- 19 851 461
- JP-A- 1 162 368
- JP-A- 58 169 972
- US-A1- 2002 158 246

## Beschreibung

Die vorliegende Erfindung betrifft ein Verfahren zur Herstellung eines vertikalen Halbleiterbauelements, das einen Halbleiterkörper mit einem Innenbereich, wenigstens einem in dem Innenbereich vorhandenen pn-Übergang und einen zwischen dem Innenbereich und einem Rand angeordneten Randbereich aufweist. Derartige Bauelemente werden bei Anlegen einer geeigneten Spannung in vertikaler Richtung, also senkrecht zu einer Vorderseite und einer Rückseite des Halbleiterkörpers, von einem Strom durchflossen. Ein derartiges vertikales Halbleiterbauelement mit einem Innenbereich, der einen pn-Übergang aufweist und einem sich an den Innenbereich anschließenden Randbereich ist beispielsweise in der US 6,351,024 B1 beschrieben.

Beim Abschalten derartiger Halbleiterbauelemente, also beim Anlegen einer Spannung, bei der der pn-Übergang sperrt, kommt dem Randbereich eine wichtige Bedeutung zu, wie nachfolgend kurz erläutert ist. Bei leitend gepoltem pn-Übergang werden die Randbereiche durch Diffusion ebenfalls mit Ladungsträgern, also Elektroden und Löchern, überschwemmt. Beim Abschalten des Bauelements müssen diese Ladungsträger aus den Randbereichen abgeführt werden, was dazu führt, dass in solchen Bereichen des Innenbereiches, die sich an den Randbereich anschließen, eine deutlich höhere Ladung abgeführt werden muss, als in den übrigen Bereichen des Innenbereiches. Die aus den Randbereichen beim Abschalten abfließenden Ladungsträger, insbesondere Löcher, können dabei zur Erzeugung zusätzlicher Ladungsträger beitragen (Lawineneffekt), was zu erhöhten Schaltverlusten durch die dynamisch einsetzenden Lawineneffekte und im ungünstigsten Fall zu einer Zerstörung des Bauelements führt. Diese beim Abschalten im Randbereich gegenüber dem Innenbereich erhöhte Stromdichte begrenzt die mittels des Bauelements insgesamt schaltbaren Ströme.

Zur Reduzierung dieses Problems ist es aus der oben genannten US 6,351,024 B1 grundsätzlich bekannt, die Ladungsträgerlebensdauer im Randbereich abzusenken. Dies erfolgt beispielsweise durch Erzeugen zusätzlicher Rekombinationszentren mittels Bestrahlung des Randbereiches mit hochenergetischen Teilchen. Nachteilig bei dem bekannten Verfahren ist, dass eine aufwendige Technik mit schwer zu justierenden metallischen Masken erforderlich ist. Außerdem soll vorteilhafterweise auch die Ladungsträgerlebensdauer im Innenbereich des Bauelements abgesenkt werden, was eine zweite aufwendige Masken- und Bestrahlungstechnik erfordert.

Die JP 58169972 A1 (Patent abstract of Japan) beschreibt ein Verfahren zur Herstellung eines Thyristors, bei dem zur Einstellung der Minoritätsladungsträgerlebensdauer ein Halbleiterkörper unter Verwendung von Katodenelektroden als Masken mit Elektronen bestrahlt wird.

Die EP 0 837 506 A2 beschreibt ein Halbleiterbauelement mit einem pn-Übergang und mit beabstandet zueinander angeordneten Defektzonen zur Einstellung der Ladungsträgerlebensdauer.

Ziel der vorliegenden Erfindung ist es deshalb, ein einfaches und kostengünstiges Verfahren zur Herstellung eines vertikalen Halbleiterbauelementes mit verbesserten Abschalteigenschaften zur Verfügung zu stellen.

Diese Ziel wird durch ein Verfahren gemäß der Merkmale des Anspruchs 1 gelöst.

Das erfindungsgemäße Verfahren zur Herstellung eines Halbleiterbauelementes umfasst das Bereitstellen eines Halbleiterkörpers, der eine Vorderseite, eine Rückseite, einen Innenbereich, einen Rand und einen Randbereich, der zwischen dem Innenbereich und dem Rand angeordnet ist, aufweist und der eine erste Halbleiterzone eines ersten Leitungstyps im Innenbereich und Randbereich und wenigstens eine im Innenbereich im Bereich der Vorderseite angeordnete zweite Halbleiterzone eines zweiten, zu dem ersten Leitungstyp komplementären Leitungstyps aufweist. Die Erzeugung derartiger Halbleiterkörper miteinem pn-Übergang im Innenbereich und miteinem Randbereich ist hinlänglich bekannt, so dass hierauf nicht weiter eingegangen wird.

Auf der zweiten Halbleiterzone an der Vorderseite des Halbleiterkörpers wird anschließend eine Anschlusselektrode erzeugt, über welche die zweite Halbleiterzone des späteren Bauelements elektrisch kontaktierbar ist. Anschließend wird die Vorderseite des Halbleiterkörpers mit hochenergetischen Teilchen, beispielsweise Protonen oder Heliumatomen, bestrahlt, wobei die Anschlusselektrode als Maske für das Bestrahlungsverfahren dient und dafür sorgt, dass die Teilchen in dem von der Anschlusselektrode überdeckten Bereich der Innenzone weniger tief in den Halbleiterkörper eindringen als in dem nicht durch die Anschlusselektrode überdeckten Bereich der Randzone.

Die in den Halbleiterkörper eingebrachten Teilchen erzeugen Rekombinationszentren, wobei sich an die Bestrahlung vorzugsweise ein Temperaturschritt anschließt, der dazu dient die Rekombinationszentren zu stabilisieren. Als Rekombinationszentren dienen Doppelleerstellen oder A-Zentren (Leerstellen/Sauerstoff-Komplexe), die durch die Bestrahlung und den sich optional anschließenden Temperaturschritt erzeugt werden. Die Temperung wird beispielsweise bei Temperaturen zwischen 220°C und 360°C bei einer Dauer, abhängig von der Temperatur, zwischen 30 Minuten und 4 Stunden durchgeführt.

Die durch die Bestrahlung hervorgerufenen, als Rekombinationszentren dienenden Defekte weisen in einem n-dotierten Gebiet eine höhere Rekombinationswirksamkeit auf als in einem p-dotierten Gebiet und bewirken in einem n-dotierten Gebiet somit eine größere Absenkung der Ladungsträgerlebensdauer. Die Bestrahlungsenergie der hochenergetischen Teilchen und die Dicke der als Maske dienenden Anschlusselektrode sind derart aufeinander abgestimmt, dass unterhalb der Anschlusselektrode Rekombinationszentren wenigstens annäherungsweise ausschließlich in der zweiten Halbleiterzone erzeugt werden.

Hierdurch kann bei einer n-Dotierung der ersten Halbleiterzone und einer p-Dotierung der zweiten Halbleiterzone im Innenbereich in der zweite Halbleiterzone eine geringere Absenkung der Ladungsträgerlebensdauer erreicht werden, die zur Einstellung der dynamischen und statischen Eigenschaften erwünscht ist, während im Randbereich in der ersten Halbleiterzone eine gewünschte starke Absenkung der Ladungsträgerlebensdauer erreicht wird, um die erläuterten Lawineneffekte beim Abschalten zu reduzieren.

Zur Erhöhung der Spannungsfestigkeit im Randbereich ist in dem Halbleiterkörper im Bereich der Vorderseite im Randbereich wenigstens eine dritte Halbleiterzone des zweiten Leitungstyps vorhanden. Bei einem Ausführungsbeispiel sind dabei wenigstens zwei dritte Halbleiterzonen vorhanden, die in Richtung des Randes zueinander und zu der zweiten Halbleiterzone beabstandet sind. Die Wirkungsweise solcher dritter Halbleiterzonen, die den Innenbereich vorzugsweise ringförmig umschließen und deshalb als Feldringe bezeichnet werden, ist beispielsweise in Baliga: "Power Semiconductor Devices", PWS Publishing, 1995, Seiten 98-100 beschrieben.

Bei einem weiteren Ausführungsbeispiel schließt sich eine dritte Halbleiterzone an die zweite Halbleiterzone an, wobei sich die Dotierung dieser dritten Halbleiterzone in Richtung des Randes reduziert. Eine derartige Halbleiterzone wird auch als VLD-Zone (VLD=Variation of Lateral Doping) bezeichnet.

Die Bestrahlungsenergie der hochenergetischen Teilchen ist so gewählt, dass die Teilchen im Randbereich so tief in den Halbleiterkörper eindringen, dass die Rekombinationszonen im Wesentlichen unterhalb der zur Erhöhung der Spannungsfestigkeit im Randbereich dienenden dritten Halbleiterzone, also in der ersten Halbleiterzone, erzeugt werden. Der Halbleiterkörper ist am Rand vorteilhafterweise abgeschrägt, was eine weitere bekannte Maßnahme zur Erhöhung der Spannungsfestigkeit im Randbereich darstellt, was für die Wirksamkeit des Verfahrens jedoch nicht erforderlich ist.

Das erfindungsgemäße Verfahren ermöglicht auf einfache Weise unter Verwendung der Anschlusselektrode als Maske die Herstellung einer Rekombinationszone mit geringerer Rekombinationswirksamkeit in der zweiten Halbleiterzone im Innenbereich und einer Rekombinationszone mit einer höheren Rekombinationswirksamkeit in der ersten Halbleiterzone im Randbereich.

Zur Erhöhung der Spannungsfestigkeit im Randbereich sind vorzugsweise Feldringe des zweiten Leitungstyps oder eine VLD-Zone im Randbereich unterhalb der Vorderseite vorhanden.

Die vorliegende Erfindung wird nachfolgend in Ausführungsbeispielen anhand von Figuren näher erläutert. In den Figuren zeigt
- Figur 1: einen ausschnittsweisen Querschnitt durch einen Halbleiterkörper, von dem bei dem erfindungsgemäßen Verfahren ausgegangen wird,
- Figur 2: den Halbleiterkörper gemäß Figur 1 während nächster Verfahrensschritte zur Herstellung eines Halbleiterbauelements,
- Figur 3: einen ausschnittsweisen Querschnittdurch ein mittels des erfindungsgemäßen Verfahrens hergestelltes Halbleiterbauelement,
- Figur 4: eine schematische Draufsicht auf das Halbleiterbauelement gemäß Figur 3,
- Figur 5: einen ausschnittsweisen Querschnitt durch einen weiteren Halbleiterkörper, der den Ausgangspunkt für ein Ausführungsbeispiel des erfindungsgemäßen Verfahrens bildet,
- Figur 6: den Halbleiterkörper gemäß Figur 5 während weiterer Verfahrensschritte zur Herstellung des Halbleiterbauelementes,
- Figur 7: einen ausschnittsweisen Querschnitt durch ein erfindungsgemäßes Halbleiterbauelement.

In den Figuren bezeichnen, sofern nicht anders angegeben gleiche Bezugszeichen gleiche Teile mit gleicher Bedeutung.

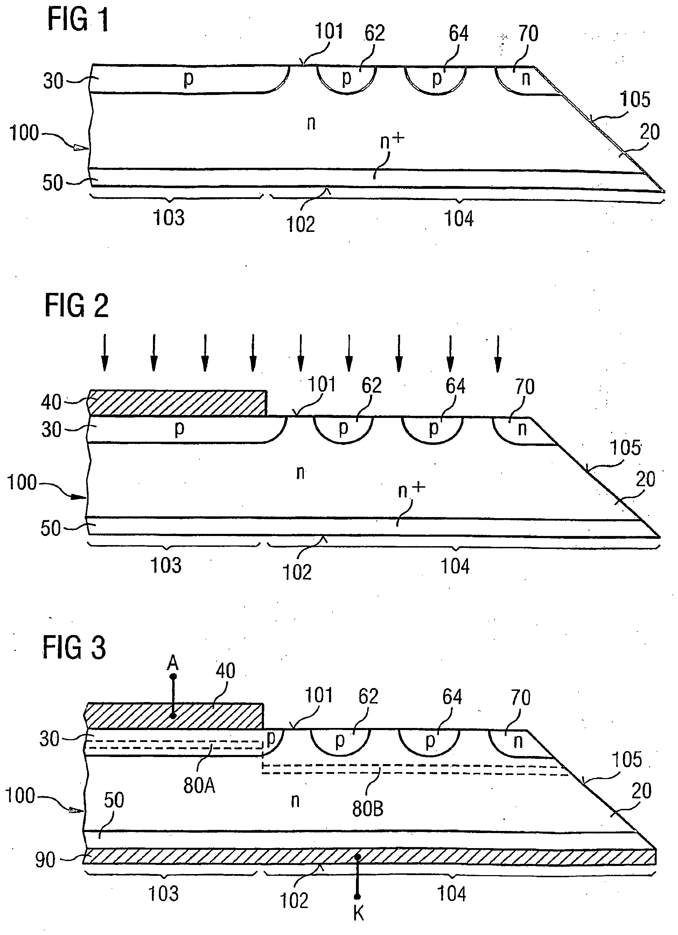

Das erfindungsgemäße Verfahren zur Herstellung eines Halbleiterbauelements wird nachfolgend anhand der Figuren 1 bis 3 für die Herstellung einer vertikalen Leistungsdiode erläutert. Das Verfahren umfasst das Bereitstellen eines Halbleiterkörpers 100, der in Figur 1 ausschnittsweise im Querschnitt dargestellt ist. Der Halbleiterkörper 100 weist eine Vorderseite 101, eine Rückseite 102 sowie einen Rand 105 auf, der in dem Ausführungsbeispiel abgeschrägt verläuft. Der Halbleiterkörper umfasst einen Innenbereich 103 beabstandet zu dem Rand 105 und einen zwischen dem Innenbereich 103 und dem Rand angeordneten Randbereich 104. Der dargestellte Halbleiterkörper 100 weist eine n-Grunddotierung auf, wobei die Halbleiterbereiche mit dieser Grunddotierung im Folgenden als erste Halbleiterzone 20 bezeichnet sind. In diese erste Halbleiterzone 20 ist im Innenbereich 103 unterhalb der Vorderseite 101 eine p-dotierte zweite Halbleiterzone 30 eingebracht, so dass im Innenbereich 103 ein pn-Übergang zwischen dieser zweiten Halbleiterzone 30 und der ersten Halbleiterzone 20 gebildet ist. Im Randbereich 104 sind unterhalb der Vorderseite 101 p-dotierte Feldringe 62, 64 vorhanden, die ausgehend von der zweiten Halbleiterzone 30 in Richtung des Randes 105 beabstandet zueinander und beabstandet zu der zweiten Halbleiterzone 30 angeordnet sind. Unmittelbar an den Rand 105 schließt sich im Bereich der Vorderseite 101 eine n-dotierte Halbleiterzone 70 an, die als Kanalstopper dient.

Der Halbleiterkörper 100 umfasst weiterhin eine stark n-dotierte fünfte Halbleiterzone 50, die sich im Bereich der Rückseite 102 an die erste Halbleiterzone 20 anschließt. Diese stark n-dotierte, als n-Emitter dienende Halbleiterzone 50 bildet die Kathodenzone des als Diode ausgebildeten späteren Halbleiterbauelementes. Die erste Halbleiterzone 20 bildet im Innenbereich 103 die n-Basis und die p-dotierte, als p-Emitter dienende zweite Halbleiterzone 30 bildet die Anodenzone. Die Feldringe 62, 64 im Randbereich 104 dienen in bekannter Weise zur Erhöhung der Spannungsfestigkeit des Bauelementes im Randbereich. Dem selben Ziel dient die ebenfalls bekannte Abschrägung des Randes 105.

Die Bereitstellung eines in Figur 1 dargestellten Halbleiterkörpers mit den erläuterten Halbleiterzonen ist hinlänglich bekannt, so dass auf eine weitere Erläuterung hierzu verzichtet werden kann.

Wie in Figur 2 dargestellt ist, wird auf die Vorderseite 101 des Halbleiterkörpers 100 im Bereich der zweiten Halbleiterzone 30 (p-Emitter) eine Anschlusselektrode 40 aufgebracht, die zur späteren elektrischen Kontaktierung des p-Emitters 30 dient. Anschließend wird die Vorderseite 101 des Halbleiterkörpers mit hochenergetischen Teilchen, beispielsweise Protonen oder Heliumatomen, bestrahlt, die in den Halbleiterkörper 100 eindringen. Die Eindringtiefe unterhalb der Anschlusselektrode 40 ist dabei geringer als in den übrigen Bereichen, da die Anschlusselektrode 40 die hochenergetischen Teilchen bereits vor dem Eindringen in den Halbleiterkörper 100 abbremst. Die Bestrahlung des Halbleiterkörpers 100 mit hochenergetischen Teilchen dient zur Erzeugung von Rekombinationszentren in dem Halbleiterkörper mit dem Ziel, die Ladungsträgerlebensdauer zu reduzieren. Diese Rekombinationszentren beispielsweise Doppelleerstellen oder A-Zentren sind durch Defekte im Kristallgitter, die durch die hochenergetischen Teilchen hervorgerufen werden, gebildet. Bei der Bestrahlung, beispielsweise mit Protonen oder Helium-Atomen, macht man sich hierbei den Effekt zu Nutze, dass die höchste Defektkonzentration in einer relativ schmalen Zone, dem sogenannten "End-of-range"-Bereich, erzeugt wird, in dem die Bestrahlungsteilchen den Großteil ihrer Energie abgeben und somit abgebremst werden.

An diese Bestrahlung mit hochenergetischen Teilchen schließt sich vorzugsweise ein Temperverfahren an, bei dem der Halbleiterkörper für eine Dauer zwischen 30 Minuten und 4 Stunden auf Temperaturen zwischen 220°C und 360°C aufgeheizt wird, um die Rekombinationszentren zu stabilisieren.

Die Eindringtiefe der hochenergetischen Teilchen ist abhängig von der Bestrahlungsenergie und im Bereich der Anschlusselektrode 40 abhängig von der Dicke dieser Anschlusselektrode 40. Die Bestrahlungsenergie und die Dicke dieser Anschlusselektrode 40 sind dabei so aufeinander abgestimmt, dass die Rekombinationszentren unterhalb der Anschlusselektrode 40 in der p-dotierten zweiten Halbleiterzone 30 erzeugt werden. Die Rekombinationszentren besitzen in der p-dotierten Zone 30 eine geringere Rekombinationswirksamkeitals in der n-dotierten ersten Halbleiterzone 20 im Randbereich, so dass die Rekombinationszentren in diesem p-dotierten Gebiet 30 eine geringere Absenkung der Ladungsträgerlebensdauer hervorrufen als in den n-dotierten Gebieten 10. Eine gewisse Absenkung der Ladungsträgerlebensdauer ist neben der ersten Halbleiterzone 20 im Randbereich 104 auch in der p-dotierten Anodenzone 30 erwünscht, um hierüber die statischen und dynamischen Eigenschaften des Bauelements einstellen zu können.

Die Bestrahlungsenergie der hochenergetischen Teilchen ist weiterhin so gewählt, dass die Rekombinationszentren im Randbereich 104 im Wesentlichen in der ersten Halbleiterzone 20 (n-Basis) unterhalb der Feldringe 62, 64 und des Kanalstoppers 70 erzeugt werden.

Figur 3 zeigt im Ergebnis schematisch die räumliche Lage der Rekombinationszentren unterhalb der Anschlusselektrode 40 im Innenbereich 103 und im Randbereich 104, wobei das Bezugszeichen 80A die Rekombinationszone in der Anodenzone 30 und das Bezugszeichen 80B die Rekombinationszone im Randbereich 104 bezeichnet. Die Rekombinationszone 80A unterhalb der Anschlusselektrode liegt dabei näher an der Vorderseite 101, da die hochenergetischen Teilchen in diesem Bereich durch die Anschlusselektrode 40 bereits abgebremst werden, bevor sie in den Halbleiterkörper 100 eindringen. Im Randbereich 104, in dem keine Anschlusselektrode vorhanden ist, dringen die hochenergetischen Teilchen entsprechend tiefer in den Halbleiterkörper 101 ein, so dass die Rekombinationszone 80B hier weiter von der Vorderseite 101 entfernt liegt. Da die Bestrahlungsenergie der einzelnen Teilchen Schwankungen unterliegt und aufgrund von statistischen Streuungseffekten in dem Halbleitergitter entstehen Rekombinationszonen 80A, 80B, die in vertikaler Richtung des Halbleiterkörpers eine bestimmte Breite aufweisen, wobei diese Breite unter Anderem von der Bestrahlungsenergie abhängig ist. Der größte Teil der Rekombinationszentren liegt dabei im sogenannten End-of-Range-Bereich der Bestrahlung.

Das erfindungsgemäße Verfahren ermöglicht in einfacher Weise die Herstellung eines vertikalen Halbleiterbauelementes mit einem pn-Übergang, in dessen Randbereich 104 durch Rekombinationszentren eine wirksame Reduktion der Ladungsträgerlebensdauer erreicht wird, wobei zusätzlich im Innenbereich 103 in der zweiten Halbleiterzone 30, die bei Dioden als p-Emitter dient, ebenfalls eine Reduktion der Ladungsträgerlebensdauer erreicht wird, die jedoch niedriger als im Randbereich ist.

Das erfindungsgemäße Verfahren ist nicht auf die Herstellung von Halbleiterdioden beschränkt sondern ist vielmehr bei beliebigen vertikalen Halbleiterbauelementen, beispielsweise MOS-Transistoren, IGBT oder Thyristoren anwendbar, die einen pn-Übergang im Innenbereich aufweisen und bei denen eine Reduktion der Ladungsträgerlebensdauer im Randbereich erwünscht ist.

Neben der oben erwähnten Möglichkeit, die Eindringtiefe der hochenergetischen Teilchen im Innenbereich 103 über die Dicke der Anschlusselektrode 40 einzustellen, besteht weiterhin die Möglichkeit, diese Eindringtiefe über die Wahl des Elektrodenmaterials zu beeinflussen. Dabei gilt, dass die hochenergetischen Teilchen um so weniger tief in den Halbleiterkörper 100 eindringen, je "dichter" das Elektrodenmaterial ist. Beispiele für geeignete Elektrodenmaterialien sind: Gold (Au), Kupfer (Cu), Molybdän (Mb), Titan (Ti) oder Wolfram (W).

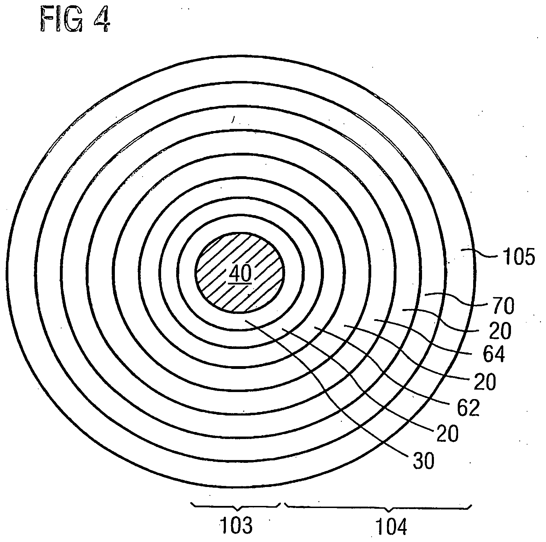

Figur 4 zeigt schematisch eine Draufsicht auf die Vorderseite 101 des in Figur 3 dargestellten Halbleiterbauelementes, das in dem Beispiel kreisförmig mit einem umlaufenden Rand 105 und Randbereich 104 ausgebildet ist. Es sei darauf hingewiesen, dass die Darstellung in Figur 4, bei der der Randbereich 104 flächenmäßig wesentlich größer als der Innenbereich 103 ist, nicht maßstabsgerecht ist.

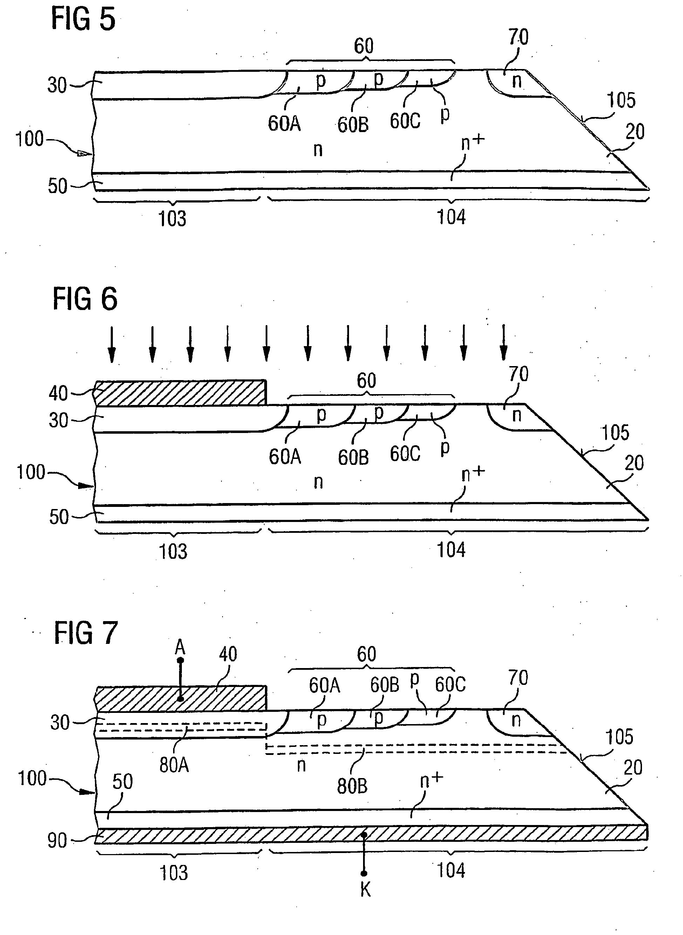

Die Figuren 5 bis 7 veranschaulichen ein Verfahren zur Herstellung eines weiteren als Diode ausgebildeten Halbleiterbauelementes, wobei sich das Verfahren von dem in den Figuren 1 bis 3 dargestellten dadurch unterscheidet, dass der verwendete Halbleiterkörper anstelle von Feldringen (Bezugszeichen 62, 64 in den Figuren 1 bis 3) eine VLD-Zone 60 als dritte Halbleiterzone aufweist, die sich in Richtung des Randes 105 an die zweite Halbleiterzone 30 anschließt und deren Dotierung ausgehend von der zweiten Halbleiterzone 30 in Richtung des Randes 105 abnimmt. Eine derartige VLD-Zone wird beispielsweise dadurch erreicht, dass die Zone 60 aus mehreren Halbleiterzonen 60A, 60B, 60C aufgebaut ist, die in lateraler Richtung nebeneinander angeordnet sind. Die Dotierung innerhalb dieser Halbleiterzonen 60A-60C kann dabei jeweils homogen sein, wobei die Dotierung von Halbleiterzone 60A, 60B zu Halbleiterzone 60B, 60C in Richtung des Randes 105 abnimmt.

Die übrigen Verfahrensschritte zur Herstellung des Halbleiterbauelementes, nämlich das Aufbringen einer Anschlusselektrode 40, das Bestrahlen der Vorderseite 101 des Halbleiterkörpers mit hochenergetischen Teilchen und, optional, ein sich an die Bestrahlung anschließender Temperschritt, entsprechen dem anhand der Figuren 1 bis 3 erläuterten Verfahren. Die Energie der hochenergetischen Teilchen ist dabei auch hier so gewählt, dass die Rekombinationszone 80B im Randbereich 104 im Wesentlichen in der n-Basis 20, also unterhalb der VLD-Zone 60 erzeugt wird.

Zur Vervollständigung der Bauelemente kann eine weitere Anschlusselektrode 90 auf die Rückseite 102 aufgebracht werden, die eine elektrische Kontaktierung der stark n-dotierten Halbleiterzone ermöglicht und die bei Dioden als Kathodenelektrode dient.

### Bezugszeichenliste

- 20: erste Halbleiterzone, n-Basis
- 30: zweite Halbleiterzone, p-Emitter
- 50: vierte Halbleiterzone, n-Emitter
- 60, 60A, 60B, 60C: VLD-Zone
- 62, 64: dritte Halbleiterzone, Feldringe
- 70: Kanalstopper
- 80A, 80B: Rekombinationszone
- 100: Halbleiterkörper
- 101: Vorderseite
- 102: Rückseite
- 103: Innenbereich
- 104: Randbereich
- 105: Rand

## Patentansprüche

1. Verfahren zur Herstellung eines Halbleiterbauelementes, das folgende Verfahrensschritte umfasst:
- Bereitstellen eines Halbleiterkörpers (100), der eine Vorderseite (101), eine Rückseite (102), einen Innenbereich (103), einen Rand (105) und einen Randbereich (104), der zwischen dem Innenbereich (103) und dem Rand (105) angeordnet ist, aufweist und der eine erste Halbleiterzone (20) eines ersten Leitungstyps im Innenbereich (103) und Randbereich (104) und wenigstens eine im Innenbereich (103) im Bereich der Vorderseite (101) angeordnete zweite Halbleiterzone (30) eines zweiten, zu dem ersten Leitungstyp komplementären Leitungstyps aufweist, wobei im Innenbereich (103) ein pn-Übergang zwischen der zweiten Halbleiterzone (30) und der ersten Halbleiterzone (20) gebildet ist,
- Herstellen einer Anschlusselektrode (40) auf der zweiten Halbleiterzone (30) auf der Vorderseite (101) des Halbleiterkörpers derart, dass die Anschlusselektrode (40) auf ihrer ganzen Fläche unmittelbar auf die zweite Halbleiterzone (30) aufgebracht ist,
- Bestrahlen der Vorderseite (101) mit hochenergetischen Teilchen unter Verwendung der Anschlusselektrode (40) als Maske, indem die Anschlusselektrode (40) und Bereiche der Vorderseite (101), die in lateraler Richtung des Halbleiterkörpers (100) an die Anschlusselektrode (40) angrenzen, direkt mit den hochenergetischen Teilchen bestrahlt werden, zur Erzeugung von Rekombinationszentren (80A, 80B) unterhalb der Anschlusselektrode (40) und unterhalb der an die Anschlusselektrode (40) in lateraler Richtung angrenzenden Bereiche der Vorderseite (101) in dem Halbleiterkörper (100), wobei die Rekombinationszentren zur Rekombination von Ladungsträgern des ersten und zweiten Leitungstyps dienen, wobei die Rekombinationszentren (80B) unterhalb der an die Anschlusselektrode (40) in lateraler Richtung angrenzenden Bereiche der Vorderseite (101) weiter von der Vorderseite (101) entfernt sind als die Rekombinationszentren (80A) unterhalb der Anschlusselektrode (40) und als der pn-Übergang und wobei die Rekombinationszentren (80A) unterhalb der Anschlusselektrode (40) wenigstens annäherungsweise ausschließlich in der zweiten Halbleiterzone (30) erzeugt werden.

2. Verfahren nach Anspruch 1, bei dem sich an das Einbringen der hochenergetischen Teilchen ein Temperaturprozess zur Stabilisierung der Rekombinationszentren in dem Halbleiterkörper (100) anschließt.

3. Verfahren nach Anspruch 2, bei dem der Temperaturprozess bei einer Temperatur zwischen 220°C und 360°C und einer Dauer zwischen 30 Minuten und 4 Stunden durchgeführt wird.

4. Verfahren nach einem der Ansprüche 1 bis 3, bei dem die hochenergetischen Teilchen Protonen oder Heliumatome sind.

5. Verfahren nach einem der vorangehenden Ansprüche, bei dem die Energie der hochenergetischen Teilchen und die Dicke der als Maske dienenden Anschlusselektrode (40) derart aufeinander abgestimmt sind, dass unterhalb der Anschlusselektrode (40) Rekombinationszentren wenigstens annäherungsweise ausschließlich in der zweiten Halbleiterzone (30) erzeugt werden.

6. Verfahren nach einem der vorangehenden Ansprüche, bei dem der Halbleiterkörper (100) im Randbereich (104) im Bereich der Vorderseite (101) wenigstens eine dritte Halbleiterzone (60; 62, 64) des zweiten Leitungstyps aufweist, wobei die Energie der hochenergetischen Teilchen so gewählt ist, dass die Rekombinationszentren im Randbereich (104) wenigstens annäherungsweise ausschließlich in der ersten Halbleiterzone (20) erzeugt werden.

7. Verfahren nach Anspruch 6, bei dem der Halbleiterkörper (100) eine dritte Halbleiterzone (60) aufweist, deren Dotierungskonzentration ausgehend von der Innenzone (103) in Richtung des Randes (105) abnimmt.

8. Verfahren nach Anspruch 7, bei dem sich die dritte Halbleiterzone (60) an die zweite Halbleiterzone anschließt.

9. Verfahren nach Anspruch 6, bei der der Halbleiterkörper (100) wenigstens zwei dritte Halbleiterzonen (62, 64) aufweist, die in Richtung des Randes (105) beabstandet zueinander und beabstandet zu der zweiten Halbleiterzone (30) angeordnet sind.

10. Verfahren nach einem der vorangehenden Ansprüche, bei dem im Bereich der Rückseite (102) des Halbleiterkörpers (100) eine vierte Zone (50) des ersten Leitungstyps erzeugt wird, die höher als die erste Zone (20) dotiert ist.

## Claims

1. Method for producing a semiconductor component, said method comprising the following method steps of:
- providing a semiconductor body (100) which has a front (101), a back (102), an inner region (103), an edge (105), an edge region (104) which is arranged between the inner region (103) and the edge (105), a first semiconductor zone (20) of a first conduction type in the inner region (103) and edge region (104) and at least one second semiconductor zone (30) of a second conduction type that is complementary to the first conduction type, said second semiconductor zone being arranged in the inner region (103) in the region of the front (101), wherein in the inner region (103) a pn-junction is formed between the second semiconductor zone (30) and the first semiconductor zone (20),
- producing a connection electrode (40) in the second semiconductor zone (30) on the front (101) of the semiconductor body, such that the connection electrode (40) is deposited on its whole surface directly on the second semiconductor zone (30),
- irradiating the front (101) with high-energy particles using the connection electrode (40) as a mask, by directly irradiating the connection electrode (40) and regions of the front (101) adjacent to the connection electrode (40) in a lateral direction of the semiconductor body (100) with the high-energy particles, in order to produce recombination centers (80A, 80B) below the connection electrode (40) and below the regions of the front (101) adjacent to the connection electrode (40) in lateral direction in the semiconductor body (100), wherein the recombination centres are used to recombine charge carriers of the first and second conductor types, wherein the recombination centres (80B), below the regions of the front (101) adjacent to the connection electrode (40) in lateral direction, are further away from the front (101) than the recombination centres (80A) below the connection electrode (40) and than the pn-junction, and wherein the recombination centers (80A) below the connection electrode (40) are produced at least approximately exclusively in the second semiconductor zone (30).

2. Method according to Claim 1, in which the operation of introducing the high-energy particles is followed by a temperature process for stabilizing the recombination centers in the semiconductor body (100).

3. Method according to Claim 2, in which the temperature process is carried out at a temperature of between 220°C and 360°C for a period of between 30 minutes and 4 hours.

4. Method according to one of Claims 1 to 3, in which the high-energy particles are protons or helium atoms.

5. Method according to one of the preceding claims, in which the energy of the high-energy particles and the thickness of the connection electrode (40) that is used as a mask are matched to one another in such a manner that recombination centers are produced, at least approximately, exclusively in the second semiconductor zone (30) beneath the connection electrode (40).

6. Method according to one of the preceding claims, in which the edge region (104) of the semiconductor body (100) has at least one third semiconductor zone (60; 62, 64) of the second conduction type in the region of the front (101), the energy of the high-energy particles being selected in such a manner that the recombination centers in the edge region (104) are produced, at least approximately, exclusively in the first semiconductor zone (20).

7. Method according to Claim 6, in which the semiconductor body (100) has a third semiconductor zone (60) whose doping concentration, starting from the inner zone (103), decreases in the direction of the edge (105).

8. Method according to Claim 7, in which the third semiconductor zone (60) adjoins the second semiconductor zone.

9. Method according to Claim 6, in which the semiconductor body (100) has at least two third semiconductor zones (62, 64) which are arranged at a distance from one another in the direction of the edge (105) and at a distance from the second semiconductor zone (30) .

10. Method according to one of the preceding claims, in which a fourth zone (50) of the first conduction type is produced in the region of the back (102) of the semiconductor body (100), said fourth zone being more highly doped than the first zone (20).

## Revendications

1. Procédé de production d'un composant à semiconducteur, qui comprend les stades de procédé suivants :
- on se procure un corps (100) semiconducteur, qui a une face (101) avant, une face (102) arrière, une zone (103) intérieure, un bord (105) et une zone (104) de bord disposée entre la zone (103) intérieure et le bord (105), et qui a une première zone (20) semiconductrice d'un premier type de conductivité dans la zone (103) intérieure et dans la zone (104) de bord et au moins une deuxième zone (30) semiconductrice disposée dans la zone (103) intérieure dans la zone de la face (101) avant, d'un deuxième type de conductivité complémentaire du premier type de conductivité, une jonction pn étant formée entre la deuxième zone (30) semiconductrice et la première zone (20) semiconductrice dans la zone (103) intérieure,
- on produit une électrode (40) de connexion sur la deuxième zone (30) semiconductrice sur la face (101) avant du corps semiconducteur, de manière à ce que l'électrode (40) de connexion soit déposée sur toute sa surface directement sur la deuxième zone (30) semiconductrice,
- on expose la face (101) avant à des particules de grande énergie en utilisant l'électrode (40) de connexion comme masque, en exposant directement l'électrode (40) de connexion et des zones de la face (101) voisines de l'électrode (40) de connexion dans la direction latérale du corps (100) semiconducteur aux particules de grande énergie, pour produire des centres (80A, 80B) de recombinaison en dessous de l'électrode (40) de connexion et en-dessous des zones de la face (101) voisines de l'électrode (40) de connexion dans la direction latérale dans le corps (100) semiconducteur, les centres de recombinaison servant à la recombinaison de porteurs de charge du premier et du deuxième types de conductivité, les centres (80B) de recombinaison en-dessous des zones de la face (101) voisines de l'électrode (40) de connexion dans la direction latérale étant à une distance plus grande de la face (101) avant que ne le sont les centres (80A) de recombinaison en dessous de l'électrode (40) de connexion et la jonction pn et les centres (80A) de recombinaison en-dessous de l'électrode (40) de connexion étant produits au moins approximativement exclusivement dans la deuxième zone (30) semiconductrice.

2. Procédé suivant la revendication 1, dans lequel fait suite à l'apport de particules de grande énergie un processus de mise en température pour stabiliser les centres de recombinaison dans le corps (100) semiconducteur.

3. Procédé suivant la revendication 2, dans lequel on effectue l'opération de mise en température à une température comprise entre 220°C et 360°C et pendant une durée comprise entre 30 minutes et 4 heures.

4. Procédé suivant l'une des revendications 1 à 3, dans lequel les particules de grande énergie sont des protons ou des atomes d'hélium.

5. Procédé suivant l'une des revendications précédentes, dans lequel on adapte l'énergie des particules de grande énergie et l'épaisseur de l'électrode (40) de connexion servant de masque l'une à l'autre, de manière à produire en dessous de l'électrode (40) de connexion des centres de recombinaison, au moins à peu près, exclusivement dans la deuxième zone (30) semiconductrice.

6. Procédé suivant l'une des revendications précédentes, dans lequel le corps (100) semiconducteur a dans la zone (104) de bord dans la zone de la face (101) avant au moins une troisième zone (60, 62, 64) semiconductrice du deuxième type de conductivité, l'énergie des particules de grande énergie étant choisie de manière à produire les centres de recombinaison dans la zone (104) de bord, au moins à peu près, exclusivement dans la première zone (20) semiconductrice.

7. Procédé suivant la revendication 6, dans lequel le corps (100) semiconducteur a une troisième zone (60) semiconductrice, dont la concentration de dopage diminue à partir de la zone (103) intérieure en direction du bord (105).

8. Procédé suivant la revendication 7, dans lequel la troisième zone (60) semiconductrice se raccorde à la deuxième zone semiconductrice.

9. Procédé suivant la revendication 6, dans lequel le corps (100) semiconducteur a au moins deux troisièmes zones (62, 64) semiconductrices, qui sont à distance entre elles dans la direction du bord (105) et à distance de la deuxième zone (30) semiconductrice.

10. Procédé suivant l'une des revendications précédentes, dans lequel on produit, dans la zone de la face (102) arrière du corps (100) semiconducteur, une quatrième zone (50) du premier type de conductivité, qui est plus dopée que la première zone (20).
